# EUROPÄISCHE PATENTANMELDUNG

(11) **EP 4 766 032 A1**
(43) Veröffentlichungstag der Anmeldung: **24.06.2026**
(21) Anmeldenummer: 25219764.5
(22) Anmeldetag: 01.12.2025
(51) Int. Cl.: H05K 1/02, G01R 31/52, H02H 5/04

(54) **ANORDNUNG MIT EINER LEITERPLATTE UND EINER SCHALTUNG ZUM FESTSTELLEN EINER KARBONISIERUNG DER LEITERPLATTE**

(30) Priorität: 20.12.2024 DE 102024139264
(71) Anmelder: HELLA GmbH & Co. KGaA, 59552 Lippstadt (DE)
(72) Erfinder: Fuisting, Manfred, 48231 Warendorf (DE)
(74) Vertreter: Behr-Wenning, Gregor

(57) **Zusammenfassung**

Die Erfindung betrifft eine Anordnung mit einer Leiterplatte und einer Schaltung zum Feststellen einer Karbonisierung der Leiterplatte, wobei auf der Leiterplatte eine Steuerschaltung (S) zum Steuern einer Leistungsschaltung (L) vorgesehen und die Steuerschaltung (S) einen Eingang für eine Versorgung der Steuerschaltung (S) mit einer Betriebsspannung hat und die Steuerschaltung (S) einen Ausgang hat, an dem die Leistungsschaltung (L) angeschlossen ist oder anschließbar ist, wobei die Schaltung (1, 2, 3, 4) zum Feststellen der Karbonisierung einen Stromsensor (1) aufweist, der mit dem Eingang der Steuerschaltung (S) für die Versorgung der Steuerschaltung (S) mit einer Betriebsspannung verbunden ist, wobei der Stromsensor (1) einen Ausgang hat, an dem ein Signal anliegt, das die Stromstärke des durch den Eingang für die Versorgung der Steuerschaltung (S) fließenden Stroms anzeigt, und einen Auswerteschaltkreis (4) aufweist, der einen Eingang hat, der mit dem Ausgang des Stromsensors (1) verbunden ist.

## Beschreibung

Die Erfindung betrifft eine Anordnung mit einer Leiterplatte und einer Schaltung zum Feststellen einer Karbonisierung der Leiterplatte, wobei auf der Leiterplatte eine Steuerschaltung zum Steuern einer Leistungsschaltung vorgesehen und die Steuerschaltung einen Eingang für eine Versorgung der Steuerschaltung mit einer Betriebsspannung hat und die Steuerschaltung einen Ausgang hat, an dem die Leistungsschaltung angeschlossen ist oder anschließbar ist.

Leiterplatten sind weit verbreitet. Sie werden verwendet, um Schaltungen darauf anzuordnen, die für die Steuerung von Funktionen, Aktoren und Sensoren im Kontext von Steuergeräten, Maschinen und Geräten verwendet werden.

Hohe, über der Spezifikation liegende Temperatureinträge auf eine Leiterplatte führen zur Alterung und Materialzersetzung in der Leiterplatte. Hierbei kann leitfähiger Kohlenstoff entstehen. Der leitfähige Kohlenstoff kann bei Entzündung (z.B. durch einen Kurzschluss von benachbarten Leiterbahnen) einen Lichtbogen entwickeln. Lichtbögen entwickeln extreme Hitze (> 1000°C). Diese kann zu einer weiteren Zerstörung der Leiterplatte bzw. der elektrischen Schaltung führen, für die die Leiterplatte verwendet wurde. Derartige Lichtbögen können nur noch durch Trennen der Spannungsversorgung unterbrochen werden. Ziel der Erfindung ist es, eine Karbonisierung der Leiterplatte vor dem Entstehen eines Lichtbogens zu erkennen.

Aus dem Dokument EP 1 615 483 A2 ist eine Leiterkarte aus einem Kunststoff mit einem Karbonisierungssensor zum Schutz vor elektrischen Schwelbränden bekannt. Der Karbonisierungssensor umfasst als Leiterbahnstrukturen zur Detektion einer Karbonisierung der Leiterplatte eine auf der Leiterkarte angeordnete erste und zweite Sensorleiterbahn, die Teil der Leiterplatte sind. Außerdem umfasst der Karbonisierungssensor ein Überwachungsmittel, das auf der Leiterplatte angeordnet sein kann. Die beiden Sensorleiterbahnen sind durch einen Kunststoff der Leiterplatte voneinander elektrisch isoliert und das Überwachungsmittel überwacht den Isolationszustand der beiden Sensorleiterbahnen zueinander. Es erzeugt ein Fehlersignal, wenn Ströme ab einer vorbestimmten Größe zwischen den beiden Sensorleiterbahnen fließen. Durch den Karbonisierungssensor wird eine Karbonisierung der Leiterkarte frühzeitig erkennbar, noch bevor die Karbonisierung, die die Leiterkarte elektrisch leitfähig macht, durch einen Lawineneffekt zu einem elektrischen Schwelbrand führt.

Die bekannte Lösung und eine sehr ähnliche, aus dem Dokument US 2005/275552 A1 bekannte Lösung können Karbonisierungen feststellen, wenn sie zu einer Veränderung der Isolation bzw. der Leitfähigkeit zwischen der ersten und der zweiten Leiterbahn führen. Es kann aber auch Fälle geben, in denen die Karbonisierung an anderen Stellen der Leiterkarte entsteht, nicht zwischen den beiden Sensorleiterbahnen des Karbonisierungssensors. So kann beispielsweise eine Karbonisierung zwischen anderen Leiterbahnen als der ersten und der zweiten Sensorleiterbahn entstehen. Das ist sogar wahrscheinlicher, da lokale Überhitzungen mit der Folge von Karbonisierung häufig in der Nähe von Bauelementen entstehen, die über die anderen Leiterbahnen und nicht über die Sensorleiterbahnen angeschlossen sind.

Es wird daher nach einer weiteren Lösung gesucht, wie die Karbonisierung einer Leiterplatte detektiert werden kann.

Diese Aufgabe wird erfindungsgemäß dadurch gelöst, dass die Schaltung zum Feststellen der Karbonisierung
- einen Stromsensor aufweist, der mit dem Eingang der Steuerschaltung für die Versorgung der Steuerschaltung mit einer Betriebsspannung verbunden ist, wobei der Stromsensor einen Ausgang hat, an dem ein Signal anliegt, das die Stromstärke des durch den Eingang für die Versorgung der Steuerschaltung fließenden Stroms anzeigt, und
- einen Auswerteschaltkreis aufweist,
   - der einen Eingang hat, der mit dem Ausgang des Stromsensors verbunden ist,
   - der eingerichtet ist, das am Ausgang des Stromsensors anliegende Signal für die Stromstärke des durch den Eingang für die Versorgung der Steuerschaltung fließenden Stroms auszuwerten, um anhand der momentanen Stromstärke oder des Verlaufs der Stromstärke eine Karbonisierung der Leiterplatte zu erkennen,
   - der eingerichtet ist, ein Warnsignal zu erzeugen, wenn eine Karbonisierung erkannt worden ist, und
   - der einen Ausgang zum Anzeigen des Warnsignals hat.

Anders als bei den aus den eingangs genannten Dokumenten bekannten technischen Lehren, wird bei einer erfindungsgemäßen Leiterplatte nicht über besondere, nur für die Erfassung einer Karbonisierung in einer Leiterplatte vorgesehene Strukturen eine Veränderung der Leiterplatte erfasst, sondern durch eine Auswertung des von der auf der Leiterplatte angeordneten Steuerschaltung aufgenommenen Stroms. Dieser Strom steigt bei einer Karbonisierung der Leiterplatte an, da es aufgrund der Karbnonisierung zu einem zusätzlichen Stromfluss kommt. Der zusätzlich fließende Strom fließt über die durch die Karbonisierung leitend gewordenen und zuvor isolierenden Teile der Leitplatte. Dieser zusätzliche Strom bzw. die durch diesen zusätzlichen Strom hervorgerufene Veränderung der Stromaufnahme und/oder im Verlauf der Stromaufnahme der Steuerschaltung kann von der erfindungsgemäß vorgesehenen Schaltung zum Feststellen der Karbonisierung mit dem erfindungsgemäß vorgesehenen Stromsensor und dem erfindungsgemäß vorgesehenen Auswerteschaltkreis erfasst werden. Die Auswerteschaltung bewertet die Stromaufnahme und kann dadurch eine Karbonisierung feststellen.

Die Auswerteschaltung einer erfindungsgemäßen Anordnung kann so eingerichtet sein, dass zum Erkennen der Karbonisierung die momentane Stromstärke mit einem vorgegebenen Wert verglichen wird, der Verlauf der Stromstärke mit einem vorgegebenen Verlauf verglichen wird, die momentane Stromstärke und/oder der Verlauf der Stromstärke mittels Mustervergleich, mittels eines künstlichen neuronalen Netzes und/oder mittels anderer Methoden der künstlichen Intelligenz bewertet wird.

Die Schaltung zum Feststellen der Karbonisierung einer Leiterplatte einer erfindungsgemäßen Anordnung kann einen Filter aufweisen, der zwischen dem Ausgang des Stromsensors und dem Eingang des Auswerteschaltkreises vorgesehen ist.

Die Schaltung zum Feststellen der Karbonisierung kann einen A/D-Umsetzer aufweisen, der zwischen dem Ausgang des Stromsensors oder dem Filter einerseits und dem Eingang des Auswerteschaltkreises andererseits vorgesehen ist.

Der Auswerteschaltkreis kann ein integrierter Schaltkreis sein, insbesondere ein Mikrocontroller.

Eine erfindungsgemäße Anordnung kann ein Teil eines Steuergeräts für ein Kraftfahrzeug sein, insbesondere für eine Beleuchtungsanlage, ein Zugangssystem, für die Steuerung des elektrischen Bordnetzes, ein Radarsystem, ein Lidarsystem usw.

Ein Beispiel für eine Anordnung aus einer Steuerschaltung, einer Leistungsschaltung und einer Schaltung zum Feststellen der Karbonisierung einer Leiterplatte ist anhand der Figur näher erläutert. Es zeigt:

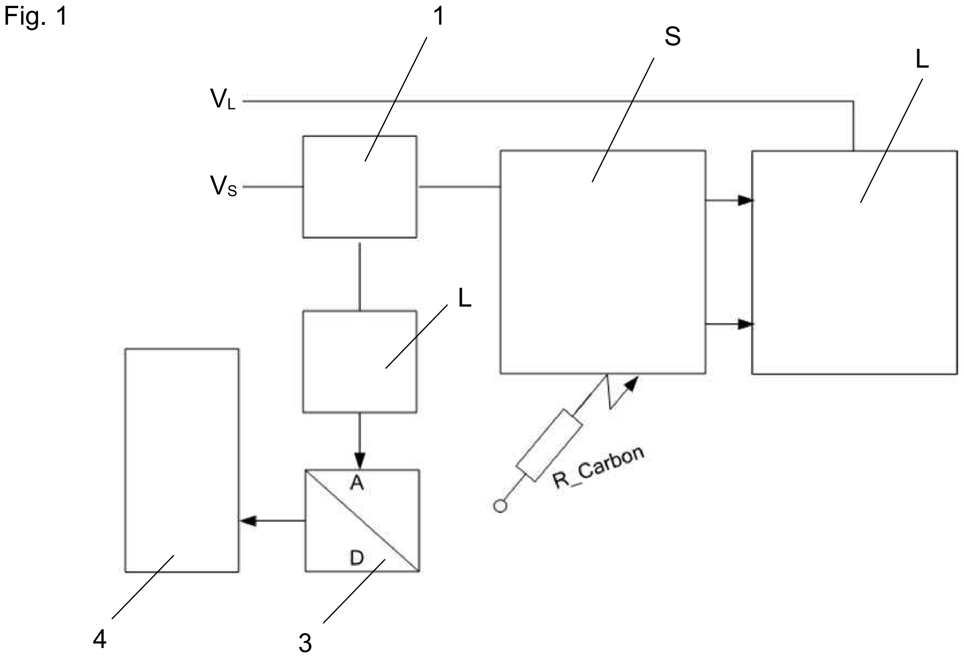

- Fig. 1: in schematischer Darstellung eine Anordnung aus einer Steuerschaltung, einer Leistungsschaltung und einer Schaltung zum Feststellen der Karbonisierung einer Leiterplatte.

Die in der Figur dargestellte Leistungsschaltung L ist an eine Spannungsversorgung für die Leistungsschaltung angeschlossen, die nicht dargestellt ist. Ebenso ist die Steuerschaltung S an eine Spannungsversorgung angeschlossen, nämlich an eine Spannungsversorgung für die Steuerschaltung S. Die Steuerschaltung S und die Leistungsschaltung L sind miteinander verbunden, so dass die Steuerschaltung S die Leistungsschaltung L ansteuern kann.

In einer Verbindung zwischen der Spannungsversorgung für die Steuerschaltung und der Steuerschaltung S ist ein Stromsensor 1 vorgesehen, der den aus der Spannungsversorgung in die Steuerschaltung fließenden Strom erfasst. An einem Ausgang des Stromsensors 1 liegt ein analoges Signal an, das den Strom repräsentiert. Der Stromsensor 1 könnte zum Beispiel ein Widerstandsbauelement umfassen. Die Spannung über diesem Widerstandsbauelement könnte abgegriffen werden und am Ausgang des Stromsensors 1 anliegen.

Das am Ausgang des Stromsensors 1 anliegende, den in die Steuerschaltung fließenden Strom repräsentierende Signal, wird im Fall des dargestellten Ausführungsbeispiels mittels eines Filters 2 gefiltert und anschließend mittels eines Analog-Digital-Umsetzers 3 in ein Digitalsignal umgesetzt, das einem Mikrocontroller 4 zugeführt wird, der das Signal auswertet.

Die Leistungsschaltung L, die Steuerschaltung S, der Stromsensor 1, das Filter 2, der Analog-Digital-Umsetzer 3 und der Mikrocontroller 4 sind auf der nicht näher dargestellten Leiterplatte angeordnet. Der Stromsensor 1, das Filter 2, der Analog-Digital-Umsetzer 3 und der Mikrocontroller 4 bilden eine Schaltung zum Feststellen der Karbonisierung der Leiterplatte.

Zum Feststellen einer Karbonisierung der Leiterplatte vergleicht der Mikrocontroller den mittels des Stromsensors 1 gemessenen Strom mit vorgegebenen Werten. Steigt der Strom über den vorgegebenen Wert an, kann die Ursache in einer Karbonisierung der Leiterplatte liegen, die zum Beispiel aufgrund einer lokalen Hitzeentwicklung dazu führt, dass die Leiterplatte lokal ihre isolierenden Eigenschaften verliert. Dadurch kann es zu einem Stromfluss über die leitende Stelle R_Carbon der Leiterplatte kommen, der zu einem Anstieg des in die Steuerschaltung fließenden Stroms führt, was dann von dem Mikrocontroller 4 detektiert und als Karbonisierung erkannt werden kann. Der Mikrocontroller 4 kann dann einem Ausgang die Karboniserung signalisieren und dazu ein Warnsignal erzeugen.

### Bezugszeichenliste

- 1: Stromsensor
- 2: Filter
- 3: Anolog-Digital-Umsetzer
- 4: Mikrocontroller
- L: Leistungsschaltung
- S: Steuerschaltung
- VL: Versorgungsspannung der Leistungsschaltung
- VS: Versorgungsspannung der Steuerschaltung
- R_Carbon: leitende Stelle der Leiterplatte

## Patentansprüche

1. Anordnung mit einer Leiterplatte und einer Schaltung zum Feststellen einer Karbonisierung der Leiterplatte, wobei auf der Leiterplatte eine Steuerschaltung (S) zum Steuern einer Leistungsschaltung (L) vorgesehen und die Steuerschaltung (S) einen Eingang für eine Versorgung der Steuerschaltung (S) mit einer Betriebsspannung hat und die Steuerschaltung (S) einen Ausgang hat, an dem die Leistungsschaltung (L) angeschlossen ist oder anschließbar ist,
**dadurch gekennzeichnet, dass**
die Schaltung (1, 2, 3, 4) zum Feststellen der Karbonisierung
• einen Stromsensor (1) aufweist, der mit dem Eingang der Steuerschaltung (S) für die Versorgung der Steuerschaltung (S) mit einer Betriebsspannung verbunden ist, wobei der Stromsensor (1) einen Ausgang hat, an dem ein Signal anliegt, das die Stromstärke des durch den Eingang für die Versorgung der Steuerschaltung (S) fließenden Stroms anzeigt, und
• einen Auswerteschaltkreis (4) aufweist,
- der einen Eingang hat, der mit dem Ausgang des Stromsensors (1) verbunden ist,
- der eingerichtet ist, das am Ausgang des Stromsensors (1) anliegende Signal für die Stromstärke des durch den Eingang für die Versorgung der Steuerschaltung (1) fließenden Stroms auszuwerten, um anhand der momentanen Stromstärke oder des Verlaufs der Stromstärke eine Karbonisierung der Leiterplatte zu erkennen,
- der eingerichtet ist, ein Warnsignal zu erzeugen, wenn eine Karbonisierung erkannt worden ist, und
- der einen Ausgang zum Anzeigen des Warnsignals hat.

2. Anordnung nach Anspruch 1, **dadurch gekennzeichnet, dass** die Auswerteschaltung (4) eingerichtet ist, zum Erkennen der Karbonisierung die momentane Stromstärke mit einem vorgegebenen Wert zu vergleichen, den Verlauf der Stromstärke mit einem vorgegebenen Verlauf zu vergleichen, die momentane Stromstärke und/oder den Verlauf der Stromstärke mittels Mustervergleich und/oder mittels eines künstlichen neuronalen Netzes oder mittels anderer Methoden der künstlichen Intelligenz zu bewerten.

3. Anordnung nach Anspruch 1 oder 2, **dadurch gekennzeichnet, dass** die Schaltung (1, 2, 3, 4) zum Feststellen der Karbonisierung einen Filter (2) aufweist, der zwischen dem Ausgang des Stromsensors (1) und dem Eingang des Auswerteschaltkreises (4) vorgesehen ist.

4. Anordnung nach einem der Ansprüche 1 bis 3, **dadurch gekennzeichnet, dass** die Schaltung (1, 2, 3, 4) zum Feststellen der Karbonisierung einen A/D-Umsetzer (3) aufweist, der zwischen dem Ausgang des Stromsensors (1) oder dem Filter (2) einerseits und dem Eingang des Auswerteschaltkreises (4) andererseits vorgesehen ist.

5. Anordnung nach einem der Ansprüche 1 bis 4, **dadurch gekennzeichnet, dass** der Auswerteschaltkreis (4) ein integrierter Schaltkreis, insbesondere ein Mikrocontroller ist.

6. Anordnung nach einem der Ansprüche 1 bis 5, **dadurch gekennzeichnet, dass** die Leistungsschaltung (L) auf der Leiterplatte angeordnet ist.

7. Steuergerät für ein Kraftfahrzeug, insbesondere für eine Beleuchtungsanlage, ein Zugangssystem, für die Steuerung des elektrischen Bordnetzes, ein Radarsystem, ein Lidarsystem usw., **dadurch gekennzeichnet, dass** das Steuergerät eine Anordnung nach einem der Ansprüche 1 bis 6 aufweist.
